Europäisches Patentamt

European Patent Office

Office européen des brevets

(11) Numéro de publication: **0 267 813 B1**

(12) **FASCICULE DE BREVET EUROPEEN**

(45) Date de publication de fascicule du brevet:
**22.01.92**

(51) Int. Cl.5: **H04N 1/18**, H05K 3/00

(21) Numéro de dépôt: **87401883.1**

(22) Date de dépôt: **14.08.87**

(54) **Phototraceur à rouleau multifaisceau.**

(30) Priorité: **20.08.86 FR 8611890**

(43) Date de publication de la demande:
**18.05.88 Bulletin 88/20**

(45) Mention de la délivrance du brevet:
**22.01.92 Bulletin 92/04**

(84) Etats contractants désignés:
**DE FR GB IT**

(56) Documents cités:

| | |
|---|---|
| EP-A- 0 092 175 | EP-A- 0 115 366 |
| DE-U- 8 505 059 | FR-A- 2 385 112 |
| FR-A- 2 413 677 | FR-A- 2 509 556 |
| GB-A- 2 075 704 | US-A- 4 513 326 |

TRANSACTIONS OF THE INSTITUTE OF METAL FINISHING, vol. 60, no. 4, 1982, pages 137-140, Londres, GB; H.R. SHEMILT: "Laser pattern generator for printed circuit artwork"

IEEE TRANSACTIONS ON COMMUNICATIONS, vol. COM-20, no. 1, février 1972, pages 23-27, New York, US; A. FUKUMOTO et al.: "High-speed facsimile recording with laser light sources"

(73) Titulaire: **Georgi, Marcel**
**35 avenue de Chanzy**
**F-94210 La Varenne St. Hilaire(FR)**

(72) Inventeur: **Frehling, André**
**45 rue de Strasbourg**
**F-94700 Maisons-Alfort(FR)**

(74) Mandataire: **Bouju, André**
**Cabinet André Bouju B.P. 6250**
**F-75818 Paris Cédex 17(FR)**

Rank Xerox (UK) Business Services

## Description

La présente invention concerne un phototraceur à rouleau multifaisceau pour imprimer des films photosensibles destinés notamment à la fabrication des circuits imprimés par photogravure.

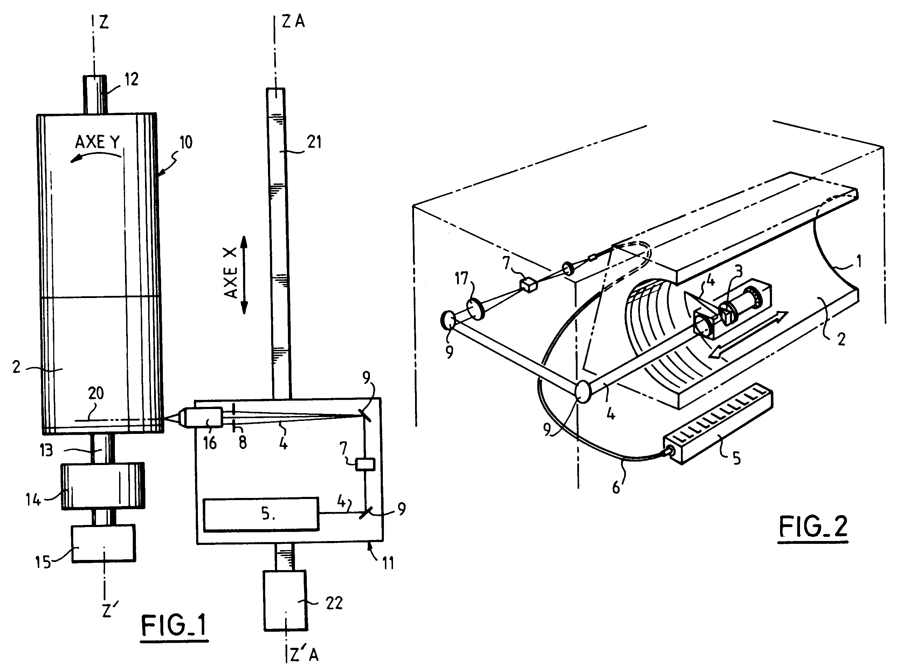

On connaît déjà un phototraceur monofaisceau qui comprend un rouleau-support de film mobile en rotation et un chariot porte-optique mobile en translation suivant un axe parallèle à l'axe du rouleau support de film. Dans cette réalisation, le chariot porte-optique supporte un dispositif optique relié optiquement à un émetteur laser par l'intermédiaire d'un filtre spatial et d'un modulateur acousto-optique pour diriger un faisceau lumineux vers le film ou interrompre ce faisceau pour allumer ou éteindre une série de lignes de spots lumineux sur le film en fonction de la rotation du rouleau et des déplacements élémentaires du chariot. Ce dispositif sera décrit plus loin de façon plus détaillée, en référence à la figure 1 des dessins annexés.

L'image obtenue au moyen de ce phototraceur est donc constituée de points ou pixels isolés sur une succession de lignes verticales et horizontales, les lignes verticales étant par exemple obtenues par le déplacement angulaire du rouleau-support de film tandis que les lignes horizontales sont obtenues par le déplacement linéaire du chariot porte-optique, celui-ci se déplaçant successivement d'une distance correspondant à un pas ou incrément de traçage.

Bien qu'une machine du genre précité donne des résultats satisfaisants, elle présente l'inconvénient de ne pas être très rapide. Or les films destinés à la fabrication des circuits imprimés qui sont par nature sensibles à la température et à l'humidité, ne peuvent pas être fabriqués à l'avance puis stockés, au risque de se déformer et de ne plus permettre de réaliser les circuits imprimés correspondants. On les réalise donc à la demande mais avec des délais réduits.

On a donc cherché à augmenter la vitesse de fabrication de tels films. Pour cela, on peut envisager d'augmenter la vitesse de rotation du rouleau-support de film. Les inconvénients inhérents à une telle augmentation de vitesse sont liés à la forte accélération angulaire du rouleau qui en résulte. Par exemple, un rouleau de diamètre 200 mm qui tourne à 1200 tours/minute présente déjà une accélération angulaire égale à 45 x g (g étant l'accélération de la pesanteur, soit 9,81 m/s$^2$). Cette accélération passe à 100 g si la vitesse du rouleau est de 1800 tours/minute et à 400 g pour une vitesse de 3600 tours/minute. Cette accélération provoque une augmentation du diamètre du rouleau de 0,023 mm à 1200 tours/minute, de 0,051 mm à 1800 tours/minute et de 0,2 mm à 3600 tours/minute. Dans ces conditions, le maintien du film contre la surface du rouleau qui est commodément réalisée par aspiration, devient très difficile et la différentielle d'allongement entre le rouleau et le film conduit, quand le film revient au repos, à une imprécision dans les dimensions du tracé qui est préjudiciable à l'obtention d'un circuit imprimé de bonne qualité.

Pour augmenter la vitesse de fabrication des films, d'autres constructeurs ont proposé une machine (illustrée à la figure 2 aux dessins annexés) dans laquelle le film est fixé à l'intérieur d'un demi-cylindre fixe le long de l'axe duquel se déplace un faisceau lumineux émis par un miroir pouvant tourner à 15000 tours/minute. Cette machine est particulièrement performante mais malheureusement extrêmement coûteuse.

On connaît d'autre part selon le FR-A-2 508 556 un phototraceur à rouleau, pour impression de films photosensibles destinés notamment à la fabrication de circuits imprimés. Ce phototraceur comprend un rouleau-support de film mobile en rotation et un chariot porte-optique mobile en translation suivant un axe parallèle à l'axe du rouleau-support de film Ce chariot porte-optique supporte un dispositif optique relié optiquement à un émetteur laser par l'intermédiaire d'au moins un modulateur acousto-optique pour diriger un faisceau lumineux vers le film ou interrompre ce faisceau pour allumer ou éteindre une série de lignes de spots lumineux sur le film en fonction de la rotation du rouleau et des déplacements élémentaires du chariot. Ce phototraceur comprend en outre des moyens pour diriger vers le film plusieurs faisceaux lumineux de manière simultanée et à partir du même émetteur laser et des moyens pour réaliser un recouvrement partiel desdits spots lumineux sur le film.

Ce phototraceur comprend plusieurs émetteurs laser, ce qui complique considérablement sa construction.

Le but de la présente invention est de proposer un phototraceur permettant d'augmenter la vitesse de traçage tout en étant d'une construction moins complexe qu'un phototraceur à plusieurs émetteurs laser.

Suivant l'invention, ce phototraceur est caractérisé en ce que l'émetteur laser est fixe et le faisceau lumineux émis par cet émetteur laser est divisé en plusieurs faisceaux lumineux dans plusieurs sous-systèmes optiques également fixes et comprenant chacun un modulateur acousto-optique et un filtre spatial, chacun de ces sous-systèmes optiques étant relié au dispositif optique porté par le chariot porte-optique au moyen d'une fibre optique.

Ainsi, on utilise un seul émetteur laser pour générer plusieurs faisceaux lumineux et tracer simultanément plusieurs lignes de pixels sur le film.

En outre, l'émetteur laser et les sous-systèmes optiques diviseurs de faisceau étant fixes et reliés par des fibres optiques au chariot porte-optique, l'optique mobile du phototraceur est réduite ce qui en augmente la fiabilité et en réduit l'inertie.

Suivant une autre forme de réalisation avantageuse de l'invention, le modulateur acousto-optique est disposé sur le chariot porte-optique et est relié à un générateur acoustique multifréquence pour dévier le faisceau incident d'un angle qui est proportionnel à la fréquence de l'onde sonore émise par le générateur acoustique, le générateur acoustique délivrant successivement, pour chaque position élémentaire du chariot, plusieurs ondes de fréquences croissantes dans un intervalle de temps suffisamment court pour que le déplacement angulaire du rouleau pendant cet intervalle de temps soit négligeable, et le dispositif optique qui est interposé entre le rouleau et le modulateur comporte un objectif de concentration et un filtre spatial interposé entre l'objectif et le modulateur pour ne laisser passer que les faisceaux déviés correspondant respectivement aux fréquences sonores précitées.

Ainsi, on utilise de même un seul émetteur laser pour générer plusieurs faisceaux lumineux et tracer plusieurs lignes de pixels sur le film dans chaque position élémentaire du chariot porte-optique.

D'autres particularités et avantages de l'invention ressortiront encore de la description ci-après.

Aux dessins annexés donnés à titre d'exemples non limitatifs :

- la figure 1 est une vue schématique en plan d'un phototraceur à rouleau à un faisceau lumineux suivant l'état de la technique,
- la figure 2 est une vue schématique en perspective d'un phototraceur à vitesse de fonctionnement améliorée suivant l'état de la technique,
- la figure 3 est une vue schématique en plan d'un phototraceur à rouleau multifaisceau suivant une première forme de réalisation de l'invention,
- la figure 4 illustre la disposition des fibres optiques dans le bloc de raccordement des fibres monté sur le chariot porte-optique du phototraceur de la figure 3,
- la figure 5 illustre les déplacements élémentaires du chariot porte-optique dans le phototraceur de la figure 3,
- la figure 6 est une vue schématique en plan d'un phototraceur multifaisceau suivant une seconde forme de réalisation de l'invention,
- la figure 7 illustre, dans le phototraceur de la figure 6, l'avance du rouleau-support de film, pour une position déterminée du chariot porte-optique, entre le traçage du premier pixel et celui du dixième,
- les figures 8 et 9 illustrent d'autres dispositions des fibres optiques dans le bloc de raccordement des fibres,
- la figure 10 est un schéma d'un circuit analogique de compensation du retard de faisceau lumineux,
- la figure 11 représente les moyens de réglage d'un modulateur acousto-optique conforme à l'invention,
- les figures 12 et 13 représentent les moyens de réglage d'un sous-ensemble optique conforme à l'invention, et
- la figure 14 représente le dispositif optique de la première forme de réalisation de l'invention.

La figure 2 illustre le phototraceur à miroir tournant déjà évoqué dans le présent préambule, cette figure n'étant fournie que pour illustrer l'état de la technique. Ce phototraceur comprend un demi-cylindre 1 contre la surface intérieure duquel est disposé un film photosensible 2 que l'on souhaite impressionner de manière appropriée à la fabrication d'un circuit imprimé déterminé. On ne décrira pas la méthode de fabrication du circuit imprimé à partir du film impressionné qui est connue en elle-même. A l'intérieur du demi-cylindre 1, un miroir 3 monté sur roulements à billes peut tourner jusqu'à 15000 tours/minute et se déplacer en translation, parallèlement au film 2, suivant l'axe du demi-cylindre 1. Ce miroir 3 est destiné à réfléchir un faisceau lumineux 4 émis par une source laser 5 et acheminé vers le miroir tournant 3 par une fibre optique 6, un modulateur acousto-optique 7, un agrandisseur de faisceau 17 et un jeu de miroirs fixes 9. Suivant les déplacements angulaire et linéaire du miroir tournant 3, le faisceau lumineux 4 balaye le film 2 tandis que le modulateur acousto-optique 7 est utilisé en interrupteur optique rapide pour allumer ou éteindre un spot lumineux sur le film en fonction du tracé souhaité.

Une telle machine, aussi performante soit-elle, présente le gros inconvénient d'être particulièrement coûteuse.

En vue d'obtenir des performances comparables à celles de la machine précitée, mais dans des conditions économiques beaucoup plus favorables, l'invention a au contraire prévu de perfectionner le phototraceur déjà évoqué et représenté à la fig.1, lequel comprend plus précisément un rouleau-support de film 10 mobile en rotation autour de son axe Z-Z' et un chariot porte- optique 11 mobile en translation suivant un axe ZA-Z'A parallèle à l'axe Z-Z' du rouleau-support de film 10. Le film photosensible 2 est maintenu pressé contre la surface extérieure du rouleau-support 10 par aspiration, ce rouleau-support étant creux et sa paroi latérale percée de trous (non représentés) tandis que l'une 12 des extrémités du rouleau-support 10 est reliée à des moyens d'aspiration (non représentés). L'autre extrémité 13 du rouleau-support 10 est reliée à un moteur d'entraînement électrique 14 tandis que la position angulaire du rouleau-support 10 est contrôlée par un générateur d'impulsions 15 lui-même solidaire en rotation de l'arbre du moteur 14. Ce générateur d'impulsions délivre, après multiplication électronique, une impulsion par incrément de traçage, c'est-à-dire dans ce cas, le déplacement angulaire du rouleau-support 10 correspondant à l'intervalle séparant deux spots ou pixels sur le film, intervalle dit pas de traçage. Dans ce type de machine, le pas de traçage est préférentiellement égal à 0,0254 mm ou 0,0127 mm mais il peut être encore de valeur plus faible. Il est évident que plus le pas de traçage est petit, meilleure est la précision du tracé, mais bien entendu, cela augmente la durée de fabrication du film et nécessite une machine plus précise et donc plus coûteuse.

Par ailleurs, le chariot porte-optique 11 supporte un dispositif optique 16 qui est dans ce cas un objectif apte à déterminer le diamètre souhaité des spots lumineux sur le film, ainsi qu'un émetteur laser 5 qui est relié optiquement à l'objectif 16 par l'intermédiaire d'un premier miroir 9, d'un modulateur acousto-optique 7, d'un second miroir 9 et d'un filtre spatial 8.

De manière connue, on utilise le modulateur acousto-optique 7 associé au filtre spatial 8, en interrupteur optique rapide. Ainsi, ce modulateur comprend un cristal dont on modifie l'indice de réfraction en l'excitant au moyen d'une onde sonore hyperfréquence de manière à dévier le faisceau incident d'un angle qui est proportionnel à la fréquence de l'onde sonore excitatrice. Plus précisément, lorsque le modulateur 7 n'est pas excité, le faisceau incident n'est pas dévié de sorte qu'après réflexion à angle droit sur le second miroir 9, il soit arrêté par le filtre spatial 8 sur les parois duquel il vient frapper. Lorsque le modulateur 7 est excité, le faisceau incident est dévié de manière qu'après réflexion sur le second miroir 9, il passe à travers l'ouverture du filtre spatial 8 puis est dirigé vers le film 2 par l'objectif 16.

Ainsi, en excitant ou non le modulateur acousto-optique 7, on dirige le faisceau lumineux 4 vers le film 2 ou on interrompt ce faisceau de manière à allumer ou éteindre une série de lignes 20 de spots lumineux (ou pixels) sur le film en fonction de la rotation du rouleau-support 10 et des déplacements élémentaires du chariot porte-optique 11 et selon le tracé souhaité. Le tracé obtenu est donc constitué de points isolés sur une succession de lignes verticales (axe Y) et horizontales (axe X), les lignes verticales étant obtenues par le déplacement angulaire du rouleau-support 10, tandis que les lignes horizontales sont obtenues par le déplacement linéaire du chariot 11, celui-ci se déplaçant successivement d'une distance correspondant au pas ou à l'incrément de traçage du phototraceur (par exemple, 0,0254 mm ou 0,0127 mm). Dans le phototraceur de la figure 1, le déplacement linéaire du chariot porte-optique 11 est réalisé par une vis à billes 21 entraînée par un moteur électrique 22.

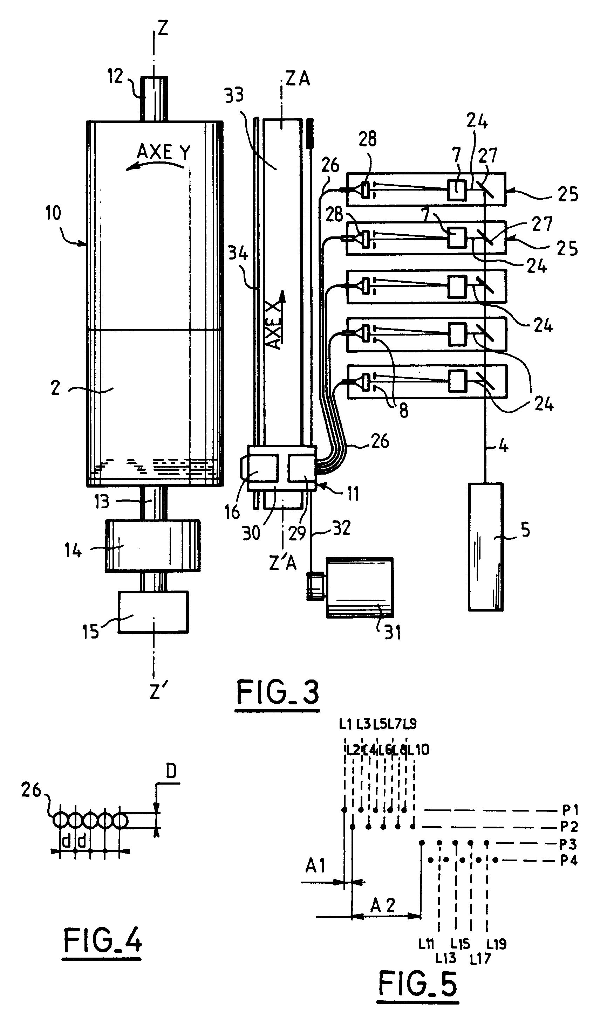

On va maintenant décrire les deux formes de réalisation perfectionnées selon l'invention en référence aux figures 3 à 7, sans détailler les parties de ces deux machines comparables à celles déjà décrites en référence à la figure 1.

Le phototraceur de la figure 3 comprend un émetteur laser 5 qui est fixe par rapport au chariot porte-optique 11 et dont le faisceau lumineux 4 est divisé en plusieurs faisceaux lumineux 24 (cinq dans l'exemple illustré) dans cinq sous-systèmes optiques 25 également fixes par raport au chariot porte-optique 11, chacun de ces sous-systèmes optiques 25 étant relié à ce chariot porte-optique au moyen d'une fibre optique 26 pour diriger vers le film photosensible 2 monté sur le rouleau-support 10, dans chaque position du chariot porte-optique 11, plusieurs faisceaux lumineux simultanément. Pour des raisons économiques, il n'est pas intéressant de prévoir plus de cinq sous-systèmes optiques.

Dans l'exemple illustré, les sous-systèmes optiques 25 sont disposés parallèlement les uns aux autres et perpendiculairement au faisceau laser 4 ainsi qu'à la direction de déplacement du chariot 11 (axe X) et qu'à l'axe Z-Z′ du rouleau-support 10. Chaque sous-système optique 25 comprend, en alignement, un miroir diviseur de faisceau 27 adapté à diviser à angle droit une partie du faisceau laser incident 4 (dans l'exemple illustré un cinquième de la puissance de ce faisceau pour le premier miroir, un quart pour le deuxième, un tiers pour le troisième et la moitié pour le quatrième miroir), un modulateur acousto-optique 7 et un filtre spatial 8 fonctionnant en interrupteur optique rapide comme décrit précédemment et un dispositif optique de concentration 28 relié à la fibre optique 26 pour diriger le faisceau dévié 24 dans cette fibre optique. On comprend que la longueur de chacune des fibres optiques sera choisie pour permettre le déplacement linéaire du chariot porte-optique 11 sur toute la longueur du rouleau-support 10, la souplesse naturelle des fibres facilitant par ailleurs ce déplacement.

Le dispositif optique monté sur le chariot porte-optique 11 comprend un objectif 16 dont l'axe est perpendiculaire à l'axe Z-Z′ du rouleau-support de film 10 et un bloc de raccordement 29 des fibres 26 dans lequel les extrémités des fibres 26 sont disposées de manière que l'axe de ces fibres soit parallèle à l'axe de l'objectif 16. Par ailleurs, le diamètre D des fibres 26 et la distance d entre-axes de deux fibres adjacentes (fig.4) sont choisis en fonction du pas de traçage des spots lumineux sur le film 2 (0,0254 ou 0,0127 mm) et du rapport de l'objectif (1/2 ou 1) pour que le diamètre de ces spots lumineux soit compris entre une fois et demie et deux fois le pas de traçage. C'est ainsi que l'on obtient la meilleure qualité de bord de trait sur le film, ainsi que l'a révélé l'expérience.

On réalise en effet un recouvrement partiel des spots adjacents deux à deux, qui peut atteindre 50 % lorsque le diamètre de ces spots vaut deux fois le pas de traçage et on obtient par conséquent une ondulation de bord de trait extrêmement réduite.

Plus précisément, selon le rapport de l'objectif, le diamètre D des fibres fixe le diamètre du spot lumineux tandis que la distance d entre-axes de deux fibres adjacentes détermine le pas de traçage. Ainsi, avec un diamètre D des fibres égal à 45 microns environ et une distance d entre-axes de deux fibres adjacentes égale à 0.0508 mm, de sorte que les fibres sont pratiquement côte à côte, on peut, avec un objectif de rapport 1, obtenir un pas de traçage de 0,0254 mm et un diamètre de spot de 45 microns soit à peu près deux fois le pas de traçage tandis qu'on peut, avec un objectif de rapport 1/2, obtenir un pas de traçage de 0,0127 mm et un diamètre de spot de 22,5 microns soit également environ deux fois le pas de traçage.

Ainsi (fig.5), dans la première position élémentaire P1 du chariot porte-optique 11, et pendant le premier tour du rouleau-support, on trace les lignes verticales (axe Y) L1, L3, L5, L7 et L9 (puisque la distance d vaut deux fois le pas de traçage pour un objectif de rapport 1 et quatre fois ce pas pour un objectif de rapport 1/2) de sorte qu'au deuxième tour du rouleau, pour tracer les lignes L2, L4, L6, L8 et L10, il faut que l'avance A1 du chariot 11 corresponde à un pas de traçage (0,0127 ou 0,0254 mm selon le rapport de l'objectif). Pour tracer les lignes L11, L13, L15, L17 et L19 au troisième tour de rouleau, il faut ainsi que la deuxième avance A2 du rouleau corresponde à une distance égale à 9 fois le pas de traçage, et ainsi de suite.

Dans la machine unifaisceau décrite en référence à la figure 1, l'avance du chariot porte-optique correspondant à un tour de rouleau-support de film est au plus égale à une fois le pas de traçage, soit par exemple 0, 0254 mm. Si cette avance intervient pendant la rotation du rouleau, l'erreur d'équerrage, c'est-à-dire le décalage suivant l'axe du rouleau entre le premier et le dernier pixel d'une ligne verticale (axe Y), est au plus égale à une fois le pas de traçage, ce qui est acceptable.

Dans la machine multifaisceau décrite ci-avant, cette erreur d'équerrage atteindrait des valeurs inacceptables si l'avance du chariot était faite en continu puisque cette avance peut correspondre à neuf fois le pas de traçage. L'invention a ainsi prévu de faire en sorte que chaque avance du chariot intervienne pendant un temps mort de la rotation du rouleau, c'est-à-dire lorsque l'objectif se trouve placé en regard de l a région du rouleau qui ne comporte pas de film, le film ne recouvrant donc pas une bande longitudinale étroite de la surface du rouleau.

Le temps pendant lequel cette bande étroite défile devant l'objectif et donc pendant lequel doivent s'effectuer les déplacements élementaires du chariot étant très court, on utilise (fig.3), à la place de la vis à billes à trop grande inertie du phototraceur unifaisceau, soit un moteur linéaire 30, soit un moto-réducteur 31 associé à un entraînement par câble ou bande de tôle 32 de faible épaisseur (environ 0,2 mm), le chariot porte-optique étant monté sur un rail 33. Un codeur de position linéaire 34 permet par ailleurs de contrôler les déplacements linéaires du chariot porte-optique 11.

Dans le phototraceur unifaisceau de la figure 1, la commande numérique de la machine est adaptée à tracer les pixels sur le film par ordre de cote croissante sur chaque ligne verticale (axe Y).

Dans la machine à cinq faisceaux que l'on vient de décrire, l'ordre de traçage des pixels est un peu plus complexe. La commande numérique de la machine est telle que la mémoire centrale reçoive le tracé des lignes verticales par groupes de dix lignes de sorte qu'on trace d'abord le premier pixel des lignes L1, L3, L5, L7 et L9 puis, le deuxième pixel de ces mêmes lignes et ainsi de suite. Lorsque tous les pixels des lignes L1, L3, L5, L7 et L9 ont été tracés, le chariot avance d'une distance égale à une fois le pas de traçage et on trace le premier pixel des lignes L2, L4, L6, L8 et L10 puis le deuxième pixel de ces mêmes lignes et ainsi de suite. Lorsque tous les pixels des dix premières lignes ont été tracés, le chariot avance d'une distance correspondant à neuf fois le pas de traçage puis on trace comme précédemment les dix lignes suivantes.

Ce "mélange" de pixels est réalisé soit par un logiciel informatique approprié, soit par des cartes électroniques.

Par ailleurs, plutôt qu'un faisceau laser divisé par des miroirs diviseurs de faisceau, ce type de traçage "entrelacé" peut utiliser plusieurs diodes électro-luminescentes pour autant que leurs couleurs d'émission soient compatibles avec la longueur d'onde de la sensibilité des films utilisés sur ce type de machine.

On notera également la caractéristique avantageuse de modularité d'une telle machine. Ainsi, le nombre de faisceaux peut être restreint lors de l'achat puis augmenté par la suite selon les besoins. Il suffit seulement alors d'adapter la commande numérique en modifiant le logiciel ou en changeant les cartes.

On notera enfin qu'étant donné que le dessin à tracer sur le film 2 est par exemple celui d'un circuit imprimé qui exige une grande précision de tracé, il convient en particulier de retenir des fibres optiques 26 de haute qualité et d'en soigner la disposition. Ainsi, sur un trait parallèle à l'axe du rouleau 10, un intervalle de 1$\mu$s génère un décalage du bord de trait de 0,0127 mm. Or la précision requise pour le phototraceur conforme à l'invention est inférieure à 5 microns. Cela conduit à respecter une tolérance inférieure à 2 microns sur le diamètre D des fibres 26 et sur l'horizontalité de l'alignement de celles-ci. Consécutivement, il faut également assurer une concentration du faisceau lumineux laser au coeur de chaque fibre 26 afin d'obtenir en sortie une illumination de celle-ci aussi uniforme que possible.

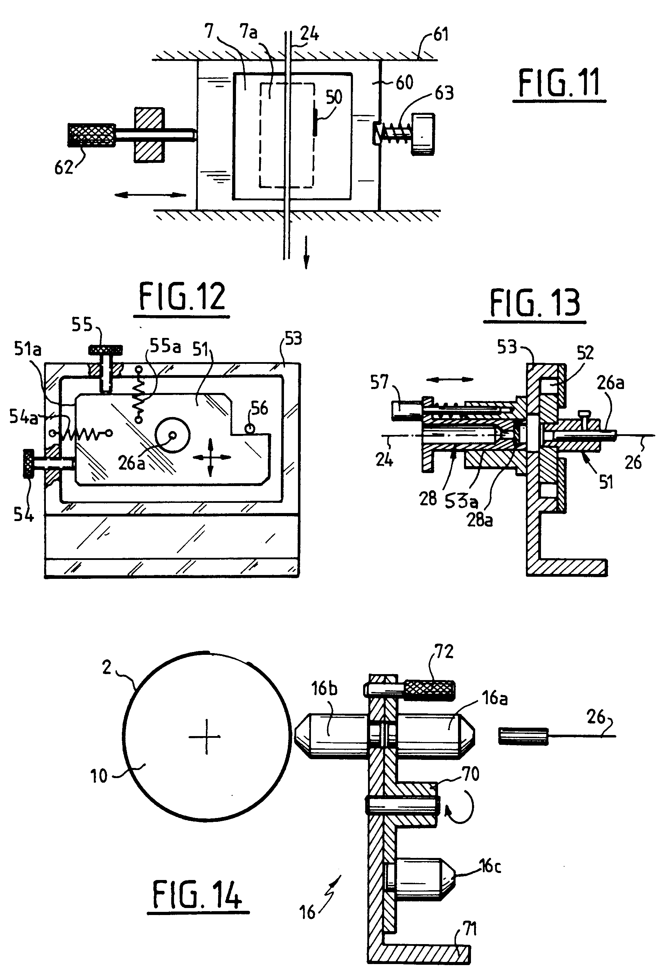

Comme on le voit aux figures 12 et 13, on a prévu ainsi selon l'invention un montage approprié de chaque embout de fibre relié au sous-système optique 25 correspondant et des moyens de réglage de cet embout par rapport au dispositif optique de concentration 28 associé. Ainsi, l'embout 26a de chaque fibre 26 est fixé dans un élément support d'embout 51 monté à double déplacement vertical et horizontal perpendiculairement à l'axe de l'embout 26a dans la glissière 52 d'un élément support 53. Les déplacements horizontal et vertical de l'élément support d'embout 51 sont obtenus au moyen respectivement de vis 54 et 55 solidaire de l'élément support 53 et dont les extrémités sont montées en appui sur les rebords 51a du support d'embout 51 (voir figure 12). L'actionnement des vis 54 et 55 provoque selon le cas la tension ou la détente de ressorts 54a et 55a permettant d'affiner le réglage de la position du support d'embout 51. Les déplacements de ce dernier sont finalement limités par une butée 56 solidaire de l'élément support 53.

Du côté opposé à l'embout de fibre 26a, l'élément support 53 est conformé pour supporter coaxialement à l'élément support d'embout 51, le dispositif optique de focalisation 28 du sous-système optique 25 considéré. Ce dernier comprend en particulier une lentille de focalisation 28a dont la distance axiale à l'embout 26a est réglable au moyen d'une vis 57 qui permet le coulissement du dispositif optique 28 dans un fourreau 53a de l'élément support 53.

Au moyen des trois vis 54, 55 et 57, il est ainsi possible de réaliser un réglage tridimensionnel du dispositif de concentration du faisceau lumineux laser dans chaque fibre optique 26.

Suivant un autre perfectionnement de l'invention, chaque modulateur acousto-optique 7 comprend des moyens de réglage qui permettent de compenser le retard de déviation du faisceau lumineux liée à la vitesse de propagation d'environ 3000 m/s de l'onde sonore hyperfréquence dans le cristal du modulateur 7, compte-tenu de la distance séparant le faisceau lumineux de l'électrode émettrice de l'onde sonore précitée.

Comme on le voit à la figure 11, chaque modulateur 7 est disposé sur un chariot porte-modulateur 60 mobile en translation le long d'un rail de guidage 61. Une vis 62 agissant sur le chariot 60 à l'encontre d'un ressort de rappel 63 permet de déplacer en translation le modulateur 7 et par conséquent de régler la distance séparant l'électrode d'excitation haute fréquence 50 du cristal de modulateur 7a du faisceau 24 traversant ce dernier.

Chacun des cinq modulateurs 7 du phototraceur multifaisceau décrit étant ainsi conçu, on peut égaliser les cinq retards correspondants avec une précision inférieure à 0,2 $\mu$s et ainsi contribuer à la qualité du tracé.

Le dispositif 16 montré sur le chariot porte-optique 11 est détaillé à la figure 14. L'objectif 16a de focale donnée F donne des fibres une image à l'infini. L'objectif 16b donne de l'image précédente une image dont le grandissement est égal à 1 si sa focale est identique à celle de l'objectif 16a et de grandissement 1/2 si sa focale vaut 2F. Pour réaliser les deux rapports 1 et 1/2 sans perte de netteté, il faut que les plans focaux des deux objectifs 16a et 16b se trouvent dans le plan des fibres 26.

Pour réaliser sélectivement les rapports 1 et 1/2, on a prévu de monter deux objectifs 16c et 16b de focales respectives F et F/2 sur un barillet rotatif 70 monté sur un support 71. Chacune des deux positions du barillet 70 est verrouillable au moyen d'un organe d'indexage 72.

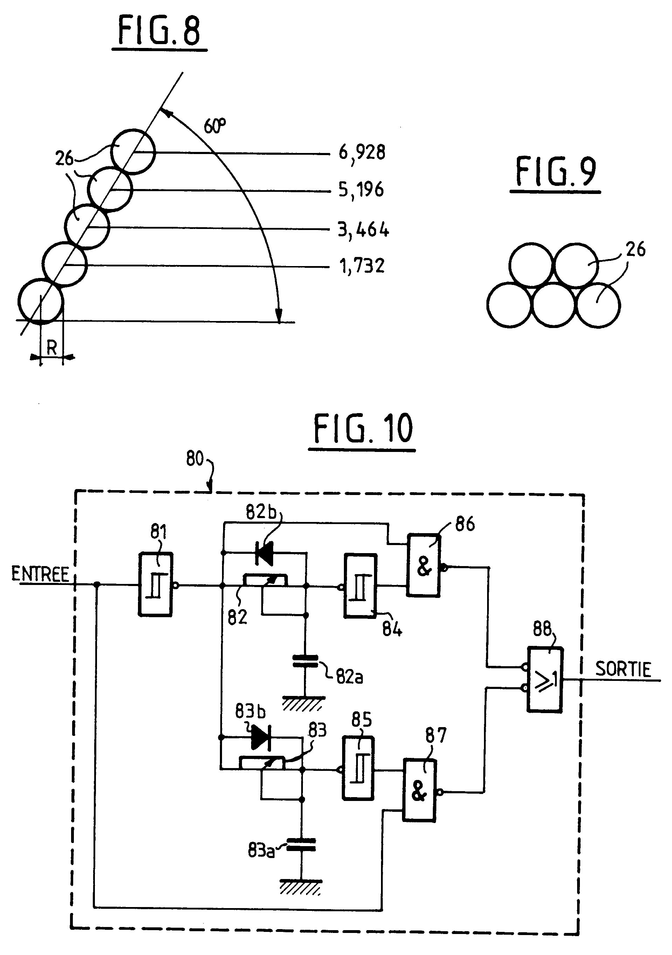

Aux figures 8 et 9, on a représenté des variantes de disposition des fibres 26 dans le bloc de raccordement 29 qui permettent d'obtenir suivant un montage mécanique simplifié un recouvrement R de 50 % des spots lumineux adjacents deux à deux.

A la figure 8 en particulier, on comprend que chaque avance élémentaire du chariot porte-optique 11 doit être égal à cinq fois le pas de traçage tandis que le retard (indiqué en nombre de pixels à la figure 8) introduit par la disposition des fibres 26 selon un axe oblique orienté de 60$°$ par rapport à l'axe du rouleau porte-film 10 doit être compensé de manière appropriée consistant à commander adéquatement la déviation des faisceaux lumineux au niveau de chaque modulateur 7 associé.

Ainsi, comme l'homme de l'art le comprendra aisément, la partie entière de chaque retard pourra être compensée en adaptant le logiciel de commande du phototraceur, tandis que la partie fractionnée pourra être compensée au moyen d'un circuit de retard électro nique 80 tel que celui de la figure 10 et associé à chaque modulateur acousto-optique 7 sur la commande d'excitation duquel il agit pour retarder sélectivement le flanc positif ou le flanc négatif de l'onde sonore d'excitation.

Ainsi ce circuit 80 comprend en entrée un premier trigger de Schmidt 81 dont la sortie est reliée à deux potentiomètres 82 et 83 dont la borne de sortie et celle de potentiel variable sont reliées à la terre par l'intermédiaire d'un condensateur respectivement 82a et 83a. Aux bornes de chaque potentiomètre 82 et 83, est montée en parallèle une diode 82b respectivement 83b, ces deux diodes étant inversées l'une par rapport à l'autre.

La sortie de chaque potentiomètre 82, 83 est reliée à un trigger de Schmidt respectivement 84, 85 dont la sortie aboutit à la première entrée d'une porte NON-ET respectivement 86, 87, la seconde entrée de la première porte NON-ET 86 étant reliée à la borne d'entrée du potentiomètre tandis que celle de la seconde porte NON-ET 87 est reliée à l'entrée du circuit 80. La sortie de chaque porte 86, 87 est finalement reliée à une troisième porte NON-ET 88 qui constitue la sortie de commande du circuit 80.

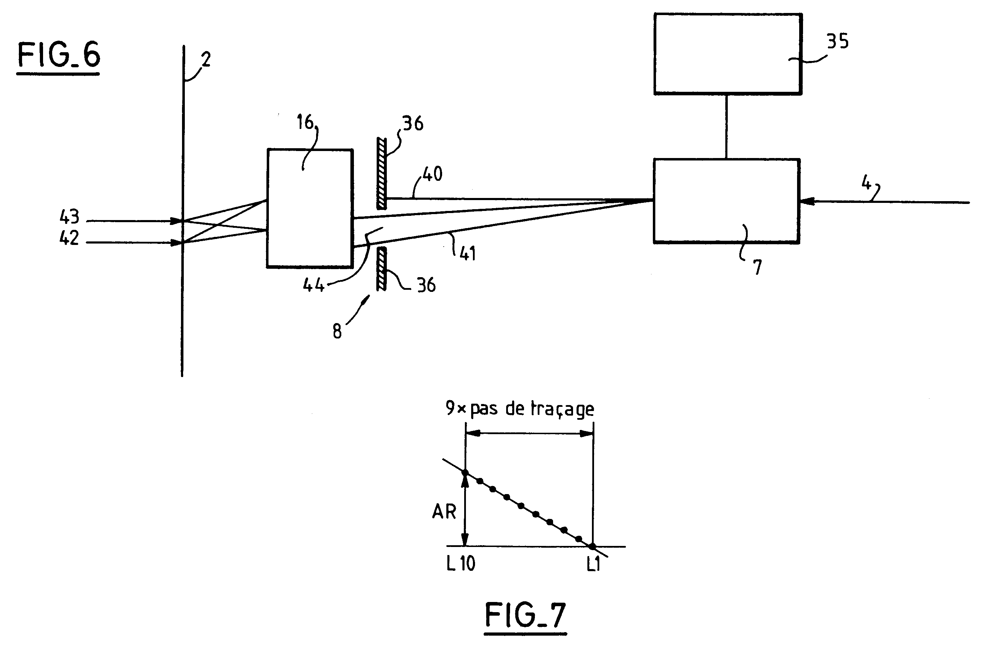

Le phototraceur multifaisceau suivant la deuxième forme de réalisation de l'invention a été représenté plus schématiquement à la figure 6, car afin de ne pas surcharger le dessin, le rouleau-support de film, le chariot porte-optique, les moyens d'entraînement du rouleau et du chariot ainsi que l'émetteur laser n'ont pas été représentés, ces organes étant comparables à ceux de la machine selon la fig. 3.

Suivant cette forme de réalisation, le chariot porte-optique (non représenté) supporte un objectif de concentration 16, un filtre spatial 8, un modulateur acousto-optique 7 et un émetteur laser (non représenté). L'émetteur laser est de préférence disposé sur le chariot porte- optique mais il pourrait également être fixe et relié au modulateur acousto-optique par exemple au moyen d'une fibre optique à condition de reconstituer optiquement en sortie de la fibre les caractéristiques du faisceau laser (parallèlisme).

Comme dans le phototraceur à cinq faisceaux décrit précédemment, un générateur acoustique multifréquence 35 qui est relié au modulateur acousto-optique 7 et de préférence installé à poste fixe est utilisé pour dévier le faisceau laser incident 4 d'un angle qui est proportionnel à la fréquence de l'onde sonore émise par ce générateur acoustique. Le modulateur acousto-optique 7 est donc d'abord utilisé en interrupteur optique rapide. Ainsi, à la figure 6, le faisceau 40, qui n'est pas dévié, est un faisceau non modulé qui émerge du modulateur lorsque celui-ci n'est pas excité, c'est-à-dire lorsqu'il ne reçoit aucune onde sonore de la part du générateur acoustique 35. Ce faisceau non dévié 40 est ainsi arrêté par l'une des parois 36 du filtre spatial 8. Par contre, quand le modulateur est excité, on obtient en sortie des faisceaux déviés tel que le faisceau 41 qui traverse l'ouverture 44 du filtre spatial 8.

En pratique, afin de tracer simultanément plusieurs lignes verticales de pixels dans chaque position élémentaire du chariot porte-optique, le générateur 35 délivre successivement dix ondes sonores de fréquence croissante qui permettent d'obtenir, en sortie du modulateur, dix faisceaux émergents dérivés d'un angle croissant proportionnellement à la fréquence des ondes sonores émises. L'ouverture 44 dans le filtre spatial 8 est ainsi dimensionnée pour ne laisser passer que les dix faisceaux modulés et donc déviés correspondant aux ondes sonores précitées.

L'objectif de concentration 16 et l'écart de fréquence entre deux fréquences successives sont déterminés pour que la distance entre deux pixels d'une même ligne horizontale sur le film 2 soit égale au pas de traçage, soit par exemple 0,0127 mm.

L'objectif 16 est également calculé pour la tâche de diffraction de chaque pixel soit suffisamment grande pour permettre un recouvrement partiel des pixels adjacents deux à deux.

Les dix fréquences sonores qui sont par exemple comprises dans l'intervalle de fréquence 80 MHz à 120 MHz, doivent être émises successivement afin d'éviter les combinaisons de fréquences qui seraient préjudiciables au tracé mais dans un intervalle de temps suffisamment court pour que le déplacement angulaire du rouleau-support de film pendant cet intervalle de temps soit aussi faible que possible. Ainsi, on peut émettre les dix fréquences à intervalle de 100 ns de sorte qu'entre le traçage du premier pixel et du dixième pixel s'écoule 0,9 microseconde.

On a représenté très schématiquement, figure 7, l'avance AR du rouleau entre le traçage d'un point déterminé de la première ligne verticale L1 et du même point de la dixième ligne L10. Pour compenser cette avance qui fausse le tracé, il faut équiper le chariot porte-optique de moyens (non représentés) qui permettent d'incliner ce chariot pendant l'avance du rouleau, suivant une direction transversale perpendiculaire à l'axe du rouleau-support de film de sorte que le pixel de la ligne L10 et celui de la ligne L1 se retrouvent sensiblement alignés suivant l'axe du rouleau.

Comme on trace dix lignes verticales dans chaque position élémentaire du chariot porte-optique, on comprend que chaque avance élémentaire de ce chariot correspond à dix fois le pas de traçage. Par ailleurs, comme dans la machine à cinq faisceaux, l'avance du chariot porte-optique se fait lorsque la bande longitudinale sans film de la surface du rouleau défile devant l'objectif.

En outre, il faut, comme dans la machine à cinq faisceaux, prévoir une commande particulière pour le traçage des pixels. Ainsi, il faut travailler par mémorisations successives de dix lignes et "envoyer" séquentiellement les pixels 1 des lignes 1 à 10, puis les pixels 2 des lignes 1 à 10 et ainsi de suite.

Ce traitement particulier peut être réalisé soit par un logiciel informatique, soit par cartes électroniques.

On notera enfin qu'à la différence de la machine à cinq faisceaux, ce phototraceur ne permet pas de choisir entre deux pas de traçage car la modification des pas de traçage qui dépend dans ce cas de plusieurs paramètres, entraînerait des aménagements de coût prohibitif.

**Revendications**

1. Phototraceur à rouleau, pour impression de films photosensibles destinés notamment à la fabrication de circuits imprimés, ce phototraceur comprenant un rouleau-support de film (10) mobile en rotation et un chariot porte-optique (11) mobile en translation suivant un axe (ZA-Z'A) parallèle à l'axe (Z-Z') du rouleau-support de film (10), le chariot porte-optique (11) supportant un dispositif optique (16, 29 ; 16, 8) relié optiquement à un émetteur laser (5) par l'intermédiaire d'au moins un modulateur acousto-optique (7) pour diriger un faisceau lumineux (4) vers le film (2) ou interrompre ce faisceau pour allumer ou éteindre une série de lignes de spots lumineux sur le film (2) en fonction de la rotation du rouleau (10) et des déplacements élémentaires du chariot (11), le phototraceur comprenant en outre des moyens (25, 26 ; 35) pour diriger vers le film (2) plusieurs faisceaux lumineux de manière simultanée et à partir du même émetteur laser (5) et des moyens pour réaliser un recouvrement partiel desdits spots lumineux sur le film (2), caractérisé en ce que ledit dispositif optique est relié optiquement à l'émetteur laser (5) par au moins un filtre spatial (8), en ce que l'émetteur laser (5) est fixe et en ce que le faisceau lumineux (4) émis par cet émetteur laser est divisé en plusieurs faisceaux lumineux (24) dans plusieurs sous-systèmes optiques (25) également fixes et comprenant chacun un modulateur acousto-optique (7) et un filtre spatial (8), chacun de ces sous-systèmes optiques étant relié au chariot porte-optique (11) au moyen d'une fibre optique (26).

2. Phototraceur conforme à la revendication 1, caractérisé en ce que les sous-systèmes optiques (25) sont disposés parallèlement les uns aux autres et perpendiculairement au faisceau laser (4) et en ce que chaque sous-système optique (25) comprend, en alignement, un miroir diviseur de faisceau (27), un modulateur acousto-optique (7), un filtre spatial (8) et un dispositif optique de concentration (28) relié à une fibre optique (26).

3. Phototraceur conforme à la revendication 2, caractérisé en ce que le dispositif optique porté par le chariot porte-optique comprend un objectif (16) dont l'axe est perpendiculaire à l'axe (Z-Z') du rouleau-support de film (10) et un bloc de raccordement (29) des fibres (26) dans lequel les extrémités des fibres (26) sont disposées de manière que l'axe de ces fibres soit parallèle à l'axe de l'objectif (16), le diamètre (D) des fibres (26) et la distance (d) entre-axes de deux fibres adjacentes étant en outre choisis en fonction du pas de traçage des spots lumineux et du rapport de l'objectif (16) pour que le diamètre de ces spots lumineux soit compris entre une fois et demie et deux fois ce pas de traçage.

4. Phototraceur conforme à l'une des revendications 1 ou 2, caractérisé en ce que le dispositif optique porté par le chariot porte-optique comprend un objectif (16) dont l'axe est perpendiculaire à l'axe (Z-Z') du rouleau-support de film (10) et un bloc de raccordement (29) des fibres (26) dans lequel les extrémités des fibres (26) sont disposées de manière que l'axe de ces fibres soit incliné d'un angle de 60° par rapport à l'axe du rouleau support de film (10).

5. Phototraceur conforme à la revendication 3, dans lequel l'objectif est de rapport égal à 1 et le pas de traçage égal à 0,0254 mm, caractérisé en ce que le diamètre (D) des fibres (26) est sensiblement égal à 45 microns et la distance (d) entre-axes de deux fibres adjacentes est égale à deux fois le pas de traçage soit 0,0508 mm.

6. Phototraceur conforme à la revendication 3, dans lequel l'objectif est de rapport égal à 1/2 et le pas de traçage égal à 0,0127 mm, caractérisé en ce que le diamètre (D) des fibres (26) est sensiblement égal à 45 microns et la distance (d) entre-axes de deux fibres adjacentes est égale à quatre fois le pas de traçage soit 0,0508 mm.

7. Phototraceur conforme à l'une des revendications 5 ou 6, caractérisé en ce que le chariot (11) avance alternativement d'une distance égale à un pas de traçage et d'une distance égale à une fois ce pas de traçage, la première avance du chariot (11) étant égale à neuf fois le pas de traçage.

8. Phototraceur conforme à l'une des revendications 1 à 7, dans lequel chaque modulateur acousto-optique (7) comprend une électrode d'émission d'onde sonore hyperfréquence (50), caractérisé en ce que chaque modulateur (7) comprend des moyens pour régler la distance séparant le faisceau lumineux le traversant de ladite électrode (50) de manière à compenser le retard de déviation du faisceau correspondant au temps de propagation de l'onde sonore entre l'électrode (50) et le faisceau lumineux.

9. Phototraceur conforme à l'une des revendications 2 à 8, caractérisé en ce que chaque sous-système optique (25) comprend des moyens de réglage tridimensionnels du dispositif de concentration (28) associé pour concentrer le faisceau laser au coeur de la fibre (26) correspondante.

10. Phototraceur conforme à la revendication 1, caractérisé en ce que le modulateur acousto-optique (7) est disposé sur le chariot porte-optique (11) et est relié à un générateur acoustique multifréquence (35) pour dévier le faisceau laser incident (4) d'un angle qui est proportionnel à la fréquence de l'onde sonore émise par le générateur acoustique (35), le générateur acoustique (35) délivrant successivement, pour chaque position élémentaire du chariot (11), plusieurs ondes de fréquences croissantes dans un intervalle de temps suffisamment court pour que le déplacement angulaire du rouleau (10) pendant cet intervalle de temps soit négligeable, et en ce que le dispositif optique qui est interposé entre le rouleau (10) et le modulateur (7) comporte un objectif de concentration (16) et un filtre spatial (8) interposé entre l'objectif (16) et le modulateur (7) pour ne laisser passer que les faisceaux déviés (41) correspondant respectivement aux fréquences sonores précitées.

11. Phototraceur conforme à la revendication 10, caractérisé en ce que le générateur multifréquence (35) génère plusieurs ondes successives en une microseconde, le filtre spatial (8) comportant une ouverture (44) adaptée à ne laisser passer que les faisceaux modulés (41) correspondant à ces fréquences et en ce que le chariot porte-optique (11) comporte des moyens d'inclinaison de ce chariot suivant une direction transversale perpendiculaire à l'axe (Z-Z') du rouleau-support de film (10) pour compenser le déplacement linéaire du rouleau (10) entre l'émission de la première onde sonore et celle de la dernière onde sonore.

12. Phototraceur conforme à l'une des revendications 10 ou 11, caractérisé en ce que l'objectif de concentration (16) permet le traçage des spots lumineux avec un pas de 0,0127 mm.

13. Phototraceur conforme à l'une des revendications 9 à 11, caractérisé en ce que chaque avance élémentaire du chariot (11) correspond à un nombre de fois le pas de traçage égal au nombre d'ondes successives émises par le générateur multifréquence (35).

14. Phototraceur conforme à l'une des revendications précédentes, dans lequel le rouleau support de film (10) comprend une région qui n'est pas recouverte par le film (2), caractérisé en ce que le déplacement du chariot porte-optique (11) intervient lorsque la région sans film du rouleau (10) défile en regard du dispositif optique (16, 29 ; 16, 8) porté par le chariot (11).

**Claims**

1. A roller phototracer for producing images on photosensitive films inter alia for the manufacture of printed circuits, the phototracer comprising a film-holding roller (10) movable in rotation and an optics-carrying slide (11) movable in translation along an axis (ZA-Z'A) parallel to the axis (Z-Z') of the film-holding roller (10), the optics-carrying slide (11) bearing an optical device (16, 29; 16, 8) optically connected to a laser emitter (5) via at least one acousto-optical modulator (7) for directing a light beam (4) towards the film (2) or switching off the beam in order to light up or extinguish a set of lines of light spots on the film (2) depending on the rotation of the roller (10) and the elementary movements of the slide (11), the phototracer further comprising means (25, 26; 35) for directing a number of light beams towards the film (2) simultaneously and from the same laser emitter (5), and means for bringing about a partial overlap of the light spots on the film (2), characterised in that said optical device is optically connected to the laser emitter via at least one spatial filter, in that the laser emitter (5) is stationary and in that the light beam (4) emitted by the laser emitter is divided into a number of light beams (24) in a number of likewise stationary optical subsystems (25) each comprising an acousto-optical modulator (7) and a space filter (8), each optical sub-system being connected to the slide (11) by an optical fibre (26).

2. A phototracer according to claim 1, characterised in that the optical sub-systems (25) are disposed parallel to one another and perpendicular to the laser beam (4) and each optical sub-system (25) comprises, in alignment, a beam-splitting mirror (27), an acousto-optical modulator (7), a space filter (8) and an optical focusing device (28) connected to an optical fibre (26).

3. A phototracer according to claim 2, characterised in that the optical device borne by the slide comprises a lens (16) having its axis perpendicular to the axis (Z-Z') of the roller (10) and also comprises a unit (29) for connecting the fibres (26), the ends of the fibres (26) therein being disposed so that the fibre axes are parallel to the axis of the lens (16), the diameter (D) of the fibres (26) and the distance (d) between the axes of each pair of adjacent fibres being also chosen in dependence on the light-spot tracing pitch and the lens ratio (16) so that the diameter of the light spots is between one and a half and twice the tracing pitch.

4. A phototracer according to one of claims 1 or 2, characterised in that the optical device borne by the slide comprises a lens (16) having its axis perpendicular to the axis (Z-Z') of the roller (10) and a unit (29) for connecting the fibres (26), the ends of the fibres (26) therein being disposed so that the fibre axes are inclined at an angle of 60° to the axis of the roller (10).

5. A phototracer according to claim 3, in which the lens ratio is unity and the tracing pitch is 0.0254 mm, characterised in that the diameter (D) of the fibres (26) is substantially equal to 45 microns and the distance (d) between the axes of each pair of adjacent fibres is equal to twice the tracing pitch, i.e. 0.0508 mm.

6. A phototracer according to claim 3, in which the lens ratio is 1/2 and the tracing pitch is 0.0127 mm, characterised in that the diameter (D) of the fibres (26) is substantially equal to 45 microns and the distance (d) between the axes of each pair of adjacent fibres is four times the tracing pitch, i.e. 0.0508 mm.

7. A phototracer according to one of claims 5 or 6, characterised in that the slide (11) alternately advances through a distance equal to the tracing pitch and through a distance equal to the tracing pitch multiplied by unity, the fist advance of the slide (11) being equal to nine times the tracing pitch.

8. A phototracer according to one of claims 1 to 7, in which each acousto-optical modulator (7) comprises an electrode for emitting an ultra-high frequency sound wave (50), characterised in that each modulator (7) comprises means for adjusting the difference between the light beam travelling through it and the electrode (50) so as to compensate the delay in deflecting the beam corresponding to the propagation time of the sound wave between the electrode (50) and the light beam.

9. A phototracer according to one of claims 2 to 8, characterised in that each optical sub-system (25) comprises means for three-dimensionally adjusting the associated focusing device (28) in order to concentrate the laser beam in the corresponding fibre (26).

10. A phototracer according to claim 1, characterised in that the acousto-optical modulator (7) is disposed on the slide (11) and is connected to a multi-frequency acoustic generator (35) for deflecting the incident laser beam (4) through an angle proportional to the frequancy of the sound wave emitted by the acoustic generator (35), the generator (35) delivering a number of waves in succession for each elementary position of the slide (11), the frequency of the waves increasing during a time short enough for the angular motion of the roller (10) to be negligible during it, and the optical device interposed between the roller (10) and the modulator (11) comprises a focusing lens (16) and a space filter (8) interposed between the lens (16) and the modulator (7) so as to admit only those beams (41) which are deflected in correspondence with the aforementioned sound frequencies.

11. A phototracer according to claim 10, characterised in that the multi-frequency generator (35) generates a number of successive waves in a microsecond, the space filter (8) having an opening (44) adapted to admit only those modulated beams (41) which correspond to the aforementioned frequencies, and the slide (11) comprises means for tilting it in a transverse direction perpendicular to the axis (Z-Z') of the film-holding roller (10) to compensate the linear motion of the roller (10) between the emission of the first sound wave and the emission of the last sound wave.

12. A phototracer according to one of claims 10 or 11, characterised in that the lens (16) can be used to trace light spots with a pitch of 0.0127 mm.

13. A phototracer according to one of claims 9 to 11, characterised in that each elementary advance of the slide (11) corresponds to a number of times the tracing pitch equal to the number of successive waves emitted by the multi-frequency generator (35).

14. A phototracer according to one of the preceding claims in which the film-holding roller (10) comprises a region not covered by the film (2), characterised in that the optics-carrying slide (11) moves when the part of the roller (10) without a film is moving opposite the optical device (16, 29 ; 16, 8) borne by the slide (11).

**Patentansprüche**

1. Optisches Trommel-Zeichengerät zum Bedrukken von photoempfindlichen Filmen, insbesondere zur Herstellung von gedruckten Schaltungen, wobei dieses optische zeichengerät eine drehbewegliche Filmträgertrommel (10) und einen Optik-Trägerwagen (11) aufweist, der translationsbeweglich entlang einer Achse (ZA-Z'A) parallel zur Achse (Z-Z') der Filmträgertrommel (10) ist, wobei der Optik-Trägervagen (11) eine optische Vorrichtung (16, 29; 16, 8) trägt, die optisch an einen Lasersender (5) über wenigstens einen akustooptischen Modulator (7) angekoppelt ist, um einen Lichtstrahl (4) auf den Film (2) zu richten oder diesen Strahl zu unterbrechen, um eine Reihe von Linien aus Lichtflecken auf dem Film (2) in Abhängigkeit von der Drehung der Trommel (10) und den elementaren Bewegungen des Wagens (11) aufzuzeichnen oder zu blockieren, wobei das optische Zeichengerät ferner Mittel (25, 26; 35) umfaßt, um mehrere Lichtstrahlen gleichzeitig und aus demselben Lasersender (5) auf den Film (2) zu richten, sowie Mittel, um eine Teilüberdeckung der Lichtflekken auf dem Film (2) zu verwirklichen, dadurch gekennzeichnet, daß die optische Vorrichtung optisch an den Lasersender (5) über wenigstens ein räumliches Filter (8) angekoppelt ist, daß der Lasersender (5) ortsfest ist und daß der von dem Lasersender emittierte Lichtstrahl (4) in mehrere Lichtstrahlen (24) durch mehrere optische Untersysteme (25) gespalten wird, die gleichfalls ortsfest sind und jeweils einen akustooptischen Modulator (7) und ein räumliches Filter (8) umfassen, und wobei jedes dieser optischen Untersysteme über eine Lichtleitfaser (26) an den Optik-Trägerwagen (11) angekoppelt ist.

2. Optisches Zeichengerät nach Anspruch 1, dadurch gekennzeichnet, daß die optischen Untersysteme (25) zueinander parallel sowie senkrecht zu dem Laserstrahl (4) angeordnet sind und daß jedes optische Untersystem (25) in einer Flucht einen Strahlteilerspiegel (27), einen akustooptischen Modulator (7), ein räumliches Filter (8) und eine optische Konzentrationsvorrichtung (28) aufweist, die an eine optische Faser (26) angekoppelt ist.

3. Optisches Zeichengerät nach Anspruch 2, dadurch gekennzeichnet, daß die von dem Optik-Träger getragene optische Vorrichtung ein Objektiv (16) aufweist, dessen Achse senkrecht zur Achse (Z-Z') der Filmträgertrommel (10) ist, sowie einen Anschlußblock (29) für die Fasern (26), worin die Enden der Fasern (26) in solcher Weise angeordnet sind, daß die Achse dieser Fasern parallel zur Achse des Objektivs (16) ist, wobei der Durchmesser (D) der Fasern (26) und der Abstand (d) zwischen den Achsen von zwei benachbarten Fasern ferner in Abhängigkeit Von Teilungsmaß beim Aufzeichnen der Lichtflecken und vom Verhältnis des Objektivs (16) gewählt sind, damit der Durchmesser dieser Lichtflecken zwischen dem Eineinhalbfachen und dem Zweifachen dieses zeichnungs-Teilungsmaßes beträgt.

4. Optisches Zeichengerät nach einem der Ansprüche 1 und 2, dadurch gekennzeichnet, daß die von dem Optik-Trägerwagen getragene optische Vorrichtung ein Objektiv (16) aufweist, dessen Achse senkrecht zur Achse (Z-Z') der Filmträgertrommel (10) ist, und einen Anschlußblock (29) für die Fasern (26), worin die Enden dieser Fasern (26) in solcher Weise angeordnet sind, daß die Achse dieser Fasern um einen Winkel von 60° in bezug auf die Achse der Filmträgertrommel (10) geneigt ist.

5. Optisches Zeichengerät nach Anspruch 3, bei welchem das Objektiv das Verhältnis 1 aufweist und das Zeichen-Teilungsmaß gleich 0,0254 mm ist, dadurch gekennzeichnet, daß der Durchmesser (D) der Fasern (26) im wesentlichen gleich 45 $\mu$m ist und der Abstand (d) zwischen den Achsen von zwei benachbarten Fasern gleich dem Zweifachen des Zeichen-Teilungsmaßes, d.h. 0,0508 mm, ist.

6. Optisches Zeichengerät nach Anspruch 3, bei welchem das Objektiv das Verhältnis 1/2 aufweist und das Zeichen-Teilungsmaß 0,0127 mm beträgt, dadurch gekennzeichnet, daß der Durchmesser (D) der Fasern (26) im wesentlichen gleich 45 $\mu$m beträgt und der Abstand (d) zwischen den Achsen von zwei benachbarten Fasern gleich dem Vierfachen Zeichen-Teilungsmaß, also 0,0508 mm, ist.

7. Optisches Zeichengerät nach Anspruch 5 oder 6, dadurch gekennzeichnet, daß der wagen (11) abwechselnd um eine Strecke, die gleich einem Zeichen-Teilungsmaß ist, und um eine Strecke, die gleich einem solchen Zeichen-Teilungsmaß ist, vorgeschoben wird, wobei der erste Vorschub des Wagens (11) gleich dem Neunfachen Zeichen-Teilungsmaß ist.

8. Optisches Zeichengerät nach einem der Ansprüche 1 bis 7, bei welchem jeder akustooptische Modulator (7) eine Elektrode (50) aufweist, von der eine akustische Höchstfrequenzwelle ausgeht, dadurch gekennzeichnet, daß jeder Modulator (7) Mittel aufweist, um den Abstand einzustellen, der zwischen dem ihn durchquerenden Lichtstrahl und der Elektrode (50) liegt, um die Strahl-Ablenkverzögerung zu kompensieren, die der Ausbreitungszeit der akustischen Welle zwischen der Elektrode (50) und dem Lichtstrahl entspricht.

9. Optisches Zeichengerät nach einem der Ansprüche 2 bis 8, dadurch gekennzeichnet, daß jedes optische Untersystem (25) Mittel zur dreidimensionalen Einstellung der zugeordneten Konzentrationsvorrichtung (28) aufweist, um den Laserstrahl auf die Mitte der entsprechenden Faser (26) zu fokussieren.

10. Optisches Zeichengerät nach Anspruch 1, dadurch gekennzeichnet, daß der akustooptische Modulator (7) auf dem Optik-Trägerwagen (11) angeordnet ist und an einen akustischen Multi-Frequenz-Generator (35) angeschlossen ist, um den auftreffenden Laserstrahl (4) um einen Winkel abzulenken, der proportional zur Frequenz der von dem akustischen Generator (35) ausgehenden Welle ist, wobei dieser akustische Generator (35) nacheinander für jede elementare Position des Wagens (11) mehrere Wellen von zunehmender Frequenz in einem Zeitintervall aussendet, das ausreichend kurz ist, damit die winkelbewegung der Trommel (10) während dieser Zeitspanne vernachlässigbar ist, und daß die optische Vorrichtung, die zwischen der Trommel (10) und dem Modulator (7) angeordnet ist, ein Konzentrationsobjektiv (16) und ein räumliches Filter (8) aufweist, das zwischen dem Objektiv (16) und dem Modulator (7) eingefügt ist, um nur solche abgelenkte strahlen (41) durchzulassen, die jeweils den genannten akustischen Frequenzen entsprechen.

11. Optisches Zeichengerät nach Anspruch 10, dadurch gekennzeichnet, daß der Multifrequenz-Generator (35) mehrere aufeinanderfolgende Wellen in einer Mikrosekunde erzeugt, wobei das räumliche Filter (8) eine Öffnung (44) aufweist, die so ausgelegt ist, daß sie nur modulierte Strahlen (41) durchläßt, die diesen Frequenzen entspricht, und daß der Optik-Trägerwagen (11) Mittel zur Neigung dieses Wagens in einer Transversalrichtung senkrecht zur Achse (Z-Z') der Filmträgertrommel (10) aufweist, um die lineare Bewegung der Trommel (10) zwischen der Emission der ersten akustischen Welle und der der letzten akustischen Welle zu kompensieren.

12. Optisches Zeichengerät nach einem der Ansprüche 10 und 11, dadurch gekennzeichnet, daß das Konzentrationsobjektiv (16) das Aufzeichnen von Lichtflecken mit einem Teilungsmaß von 0,0127 mm ermöglicht.

13. Optisches Zeichengerät nach einem der Ansprüche 9 bis 11, dadurch gekennzeichnet, daß jeder elementare Vorschub des Wagens (11) einer Anzahl von Zeichen-Teilungsmaßeinheiten entspricht, die gleich der Anzahl von aufeinanderfolgenden Wellen ist, die der Multifrequenz-Generator (35) abgibt.

14. Optisches zeichengerät nach einem der vorstehenden Ansprüche, bei welchem die Filmträgertrommel (10) einen Bereich aufweist, der von dem Film (2) nicht bedeckt ist, dadurch gekennzeichnet, daß die Bewegung des Optik-Trägerwagens (11) dann stattfindet, wenn der filmlose Bereich der Trommel (10) gegenüber der optischen Vorrichtung (16, 29; 16, 8) vorbeibewegt wird, die von dem Wagen (11) getragen wird.

FIG.2

FIG.1

FIG.3

FIG.4

FIG.5

FIG_6

9×pas de traçage

FIG_7

EP 0 267 813 B1

FIG.8

26

60°

6,928

5,196

3,464

1,732

R

FIG.9

26

FIG. 10

80

ENTREE

81

82b

82

82a

83b

83

83a

84

85

86

87

88

≥1

SORTIE

FIG.11

FIG.12

FIG. 13

FIG.14